# EUROPEAN PATENT APPLICATION

(11) **EP 2 237 324 A1**
(43) Date of publication of application: **06.10.2010**
(21) Application number: 08871605.5
(22) Date of filing: 25.09.2008
(51) Int. Cl.: H01L 31/042

(54) **SOLAR BATTERY PANEL AND METHOD FOR MANUFACTURING SOLAR BATTERY PANEL**

(30) Priority: 21.01.2008 JP 2008009995
(71) Applicant: Mitsubishi Heavy Industries, Ltd., Minato-ku Tokyo 108-8215 (JP)
(72) Inventor: HORIOKA, Tatsuji, Nagasaki-shi Nagasaki 850-8610 (JP); MAMASE, Shinichirou, Nagasaki-shi Nagasaki 851-0392 (JP)
(74) Representative: Bongiovanni, Simone
(86) International application number: PCT/JP2008/067233
(87) International publication number: WO 2009/093355

(57) **Abstract**

Provided is a solar cell panel that hardly retains any moisture between a solar cell panel body and a frame and enables automation of the process of attaching the frame to the solar cell panel body. The solar cell panel includes a solar cell panel body (3), a frame (2), and a joint (4). The solar cell panel body (3) includes a substrate (31) having a first surface (3a) on which photoelectric conversion elements (32) are mounted. The frame (2) has an approximately L-shaped cross-section. The joint (4) bonds the frame (2) and a second surface (3b), opposite to the first surface (3a), of the substrate (31).

## Description

### Technical Field

The present invention relates to solar cells.

### Background Art

Known types of solar cells include thin-film solar cells where photoelectric conversion elements are disposed directly on, for example, a glass substrate and crystalline solar cells where photoelectric conversion elements are disposed on a crystal substrate. In the thin-film solar cells, for example, the surface having the photoelectric conversion elements is covered with a filler or a sealing agent to form a solar cell panel body. On the other hand, in the crystalline solar cells, for example, crystalline photoelectric conversion elements are bonded to the substrate, and the substrate is covered with a filler or a sealing agent to form a solar cell panel body. Such solar cell panel bodies are fixed to metal frames, such as aluminum frames, to form panel structures.

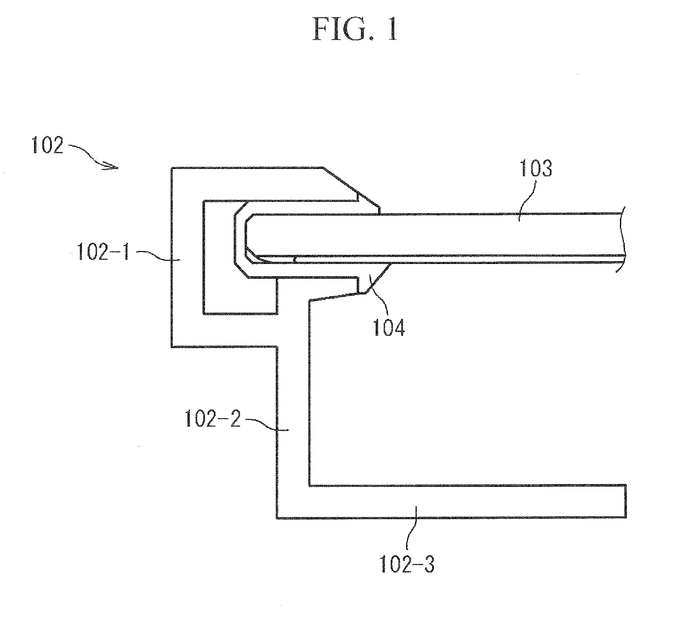

FIG. 1 is a partial cross-sectional view showing an exemplary structure of a conventional solar cell panel. The solar cell panel includes a solar cell panel body 103, a frame 102, and a gasket 104. The solar cell panel body 103 includes a thin-film solar cell module or a crystalline solar cell module. The frame 102 is a metal frame, such as an aluminum frame. The frame 102 includes a module holder 102-1 for holding the solar cell panel body 103 via the gasket 104, a shape keeper 102-3 for maintaining the shape of the frame 102, and a joint 102-2 for joining the module holder 102-1 and the shape keeper 102-3.

Conventionally, the solar cell panel body 103 is fitted to the module holder 102-1 having an approximately angular-U shaped cross-section for holding the plate-like solar cell panel body 103 with the frame 102. In such a case, the gasket 104 is used as a buffer for buffering thermal and mechanical stresses between the glass substrate of the solar cell panel body 103 and aluminum of the frame 102. Furthermore, the fin-shaped shape keeper 102-3 is disposed on the bottom to reduce widening of the frame 102 due to insufficient strength of the aluminum.

Regarding a technology relating to frames of solar cell panels, Patent Document 1 discloses a supporting frame structure for a solar cell panel. In this supporting frame structure for a solar cell panel, an outer frame serving as a reinforcement member is fitted to the periphery of a solar cell panel that is formed by vapor-depositing a semiconductor film serving as a power-generating area on a glass panel serving as a substrate, and a deformation-preventing member made of a transparent bar-shaped member, such as reinforced glass or reinforced plastic, is bonded to at least a surface of the solar cell panel. This achieves a reduction in weight of the outer frame. The frame employed here has an approximately angular-U shaped cross-section.

Patent Document 2 discloses a solar housing. This solar housing is produced by sealing a plurality of solar cell elements with a sealing agent. The periphery of a solar photovoltaic power generation module having a transparent substrate provided with the sealed solar cell elements is fitted into a frame. The periphery is fixed with the sealing agent, and portions where the terminals of the elements and the terminals of external devices are connected are sealed with a sealing agent in a terminal box. In this solar housing, the elements are sealed with a cured room-temperature-curing organopolysiloxane composition, in which deep-section curing is brought about by producing water internally as a by-product. The frame employed here has an approximately angular-U shaped cross-section.

Patent Document 3 discloses a method of producing a solar cell module. In this method of producing a solar cell module, a frame member is fixed to the periphery of a solar cell panel which is formed by laminating surface glass, solar cells, and a back sheet to form an integrated structure. In this method of producing a solar cell module, the surface glass, the solar cells, and the back sheet are temporarily fixed with an adhesive; a high-temperature-curing waterproofing agent is applied to the periphery of this temporarily fixed solar cell panel; the periphery of the solar cell panel is fitted into the channel of a frame having an approximately angular-U shaped cross-section; and the solar cell panel and the frame member at the periphery of the solar cell panel are heated to cure the adhesive agent and the waterproofing agent simultaneously. The frame employed here has an approximately angular-U shaped cross-section.

Patent Document 4 discloses a frameless solar cell module. In this frameless solar cell module, a first translucent substrate has a surface provided with a thin-film solar cell layer and an insulating layer covering the whole surface of the thin-film solar cell layer; and the surface of the insulating layer is bonded to a second translucent substrate at least having the same size as that of the first substrate, with a synthetic resin layer therebetween.

Patent Document 1: Japanese Unexamined Patent Application, Publication No. 2004-87884
Patent Document 2: Japanese Unexamined Patent Application, Publication No. 2000-349322
Patent Document 3: Japanese Unexamined Patent Application, Publication No. 2005-19507
Patent Document 4: Japanese Unexamined Patent Application, Publication No. HEI 09-331079

### Disclosure of Invention

In the solar cell panel disclosed in Patent Document 1, although the solar cell panel is reinforced with a reinforcement member, the solar cell panel body is fitted into a frame having an approximately angular-U shaped cross-section. Accordingly, there is a possibility of problems such that moisture may remain in the "angular-U" portion of the approximately angular-U shaped cross-section; use of a gasket etc. may be necessary; the back sheet may be involved in the holding; and undulation or distortion of the solar cell panel body may have some influence.

In the solar cell panel disclosed in Patent Document 2, although the frame and the solar cell panel body are connected with a room-temperature-curing organopolysiloxane, the solar cell panel body is fitted into a frame having an approximately angular-U shaped cross-section. Accordingly, there is a possibility of problems such that moisture may remain in the "angular-U" portion; and undulation or distortion of the solar cell panel body may have some influence.

In the solar cell panel disclosed in Patent Document 3, although a waterproofing agent having a temperature-reducing effect is disposed between the solar cell panel body and the frame, the solar cell panel body is fitted into a frame having an approximately angular-U shaped cross-section. Accordingly, there is a possibility of problems such that moisture may remain in the "angular-U" portion; the back sheet may be involved in the holding; and undulation or distortion of the solar cell panel body may have some influence.

Because the solar cell panel disclosed in Patent Document 4 employs a synthetic resin layer surrounding the periphery of the solar cell panel body instead of the frame, it has a frameless structure.
That is, none of the frames of the solar cell panels described in Patent Documents 1 to 4 have an approximately L-shaped cross-section.

Conventional solar cell panels, such as the one shown in FIG. 1, have a disadvantage that moisture retention easily occurs in the module-holding portion 102-1 having an approximately angular-U shaped cross-section. Such moisture often causes defects of the solar cell panel and is therefore undesirable. In addition, when the solar cell panel body 103 has a large area, the substrate has undulation, which makes it difficult to completely automate the process of attaching a frame 102 having an approximately angular-U shaped cross-section to the solar cell panel body 103. Furthermore, thermal and mechanical stresses occur between the glass substrate of the solar cell panel body 103 and the aluminum frame of the frame 102. Accordingly, a buffer, such as the gasket 104, for relieving the thermal and mechanical stresses is essential, resulting in increases in the numbers of raw materials and processes. In addition, since the gasket 104 does not fix the glass substrate to the aluminum frame, a fin-shaped shape keeper 102-3 is necessary for reducing widening of the frame 102. Furthermore, when the buffer is a sealant or the like, it is difficult to uniformly apply the buffer to the entire interface between the glass substrate and the aluminum frame. Accordingly, a large amount of surplus buffer that sticks out must be removed.

The present invention has been made under such circumstances, and an object of the present invention is to provide a solar cell panel that hardly retains any moisture and that has high reliability, and a method of fabricating the solar cell panel.

Another object of the present invention is to provide a solar cell panel that can be attached to a frame by an automated process and a method of fabricating the solar cell panel.

Another object of the present invention is to provide a solar cell panel that can be easily fabricated with a reduced number of processes at lower cost and a method of fabricating the solar cell panel.

Solutions for solving the above-mentioned problems will be described below.
The solar cell panel of the present invention includes a solar cell panel body, a frame, and a joint. The solar cell panel body includes a substrate having photoelectric conversion elements mounted on a first surface. The frame has an approximately L-shaped cross-section. The joint connects the frame and a second surface, opposite to the first surface, of the substrate.
In the present invention, the frame has an approximately L-shaped cross-section, not the approximately angular-U shaped cross-section. Therefore, the frame does not have a portion between the solar cell panel body and the frame where moisture remains, such as the "angular-U" portion of the approximately angular-U shaped cross-section. That is, moisture is not retained at the periphery inside the joint 4 and the periphery outside the solar cell panel body. Consequently, the influence of moisture on the solar cell panel body is significantly reduced, which increases the weatherability and the long-term reliability of the solar cell panel. Furthermore, a member such as a gasket, which is used in the frame having an approximately angular-U shaped cross-section, is unnecessary, which reduces the cost. In addition, the second surface of the substrate of the solar cell panel body is bonded to the frame, and the frame holds the solar cell panel body at the bonding portion. That is, the first surface of the substrate, including photoelectric conversion elements, is not involved in the holding of the solar cell panel body. Therefore, since a covering layer and a protection layer (back sheet) on the photoelectric conversion elements are not involved in the holding, the holding (adhesion) reliability is improved. Furthermore, since the structure in which the substrate of the solar cell panel body and the frame are bonded is simple, unlike the case of the frame having an approximately angular-U shaped cross-section, it is unnecessary to fit the solar cell panel body into the frame. The joint absorbs the influences of undulation, distortion, and stress-deformation of the solar cell panel body; and has a structure that allows extremely simple fabrication.

In the above-mentioned solar cell panel, the frame preferably includes a frame member and an overhang member.
The frame member here surrounds the outer edge of the solar cell panel body in a frame shape. The overhang member is connected to the frame member at substantially a right angle, toward the inside of the frame member. The joint preferably bonds the second surface and the overhang member.
In the present invention, the second surface of the substrate of the solar cell panel body is bonded to a surface of the overhang member facing thereto with the joint. Therefore, the influences of undulation, distortion, and stress-deformation of the solar cell panel body are absorbed by thickness deformation of the joint. As a result, it has a structure that allows extremely simple fabrication.

In the above-mentioned solar cell panel, it is preferable that the shadow of the adhesion region of the overhang member and the solar cell panel body, which falls on the first surface, be outside of a region having the photoelectric conversion elements.
Thus, by setting the length of the overhang member extending toward the photoelectric conversion elements, it is possible to obtain an effect whereby the approximately L-shaped cross-section does not affect the power generation by the photoelectric conversion elements.

In the above-mentioned solar cell panel, the overhang member preferably becomes thinner with the distance from the connecting portion of the frame member.
By thus making the end of the overhang member thin, sufficient distance can be secured between the end and the second surface, increasing the thickness of the joint at the end thereof. With such a large thickness, the influences of undulation, distortion, and stress-deformation of the solar cell panel body are absorbed more flexibly by thickness deformation of the joint.

In the above-mentioned solar cell panel, the frame member preferably includes a projection member that is connected to the frame member at substantially a right angle, toward the inside of the frame member at the other end of the frame member with respect to the connecting portion of the overhang member and that is shorter than the overhang member.
In the present invention, the substrate of the solar cell panel body and the frame are bonded, and the frame holds the solar cell panel body at that portion. That is, since the substrate and the frame are directly bonded, the frame is prevented from widening due to the substrate. Therefore, it is possible to reduce the size of the projection member. As a result, after assembling the frame, the solar cell panel body can be inserted into the frame and has a structure that allows extremely simple fabrication.

In the above-mentioned solar cell panel, the joint preferably includes an adhesion portion and a filling portion. The adhesion portion here bonds the second surface and the frame. The filling portion is provided so as to fill a recess surrounded by the end of the solar cell panel body, the adhesion portion, and the frame.
In the present invention, since the filling portion fills the recess surrounded by the end of the solar cell panel body, the adhesion portion, and the frame, a structure in which it is made more difficult for moisture to remain is obtained. This further enhances the long-term reliability of the solar cell panel.

In the above-mentioned solar cell panel, it is preferable that the joint further include a sealing portion that is disposed so as to be in contact with the filling portion and to cover the end of the solar cell panel body.
Since the sealing portion thus covers the end of the solar cell panel body where the covering layer is relatively easily deteriorated, infiltration of moisture due to deterioration of the end of the solar cell panel body can be prevented.

In the above-mentioned solar cell panel, the adhesion portion preferably contains any of polyurethane, silicone, and a silyl group-containing polymer.
In the present invention, it is possible to achieve more secure joining by using a material, such as polyurethane, silicone, or a silyl group-containing polymer, in the adhesion portion.

An aspect of the method of fabricating the solar cell panel of the present invention includes (a) a solar cell panel body-producing step of producing a solar cell panel body including a substrate having photoelectric conversion elements mounted on a first surface; (b) an application step of applying an adhesive to a frame having an approximately L-shaped cross-section; and (c) an adhesion portion-forming step of forming an adhesion portion bonding the frame and a second surface, opposite to the first surface, of the substrate.
In the present invention, the frame has an approximately L-shaped cross-section instead of an approximately angular-U shaped cross-section. Accordingly, the solar cell panel is fabricated by press bonding the second surface of the substrate of the solar cell panel body to the frame, and it is unnecessary to fit the solar cell panel into the frame, unlike the case of the frame having an approximately angular-U shaped cross-section. Therefore, since the process for fitting the solar cell panel body into the frame can be omitted, a solar cell panel body can be fabricated extremely simply. In addition, the influences of undulation, distortion, and stress-deformation of the solar cell panel body are absorbed by the joint.

In the above-mentioned method of fabricating the solar cell panel, the frame includes a frame member surrounding the outer edge of the solar cell panel body in a frame shape and an overhang member connected to the frame member at substantially a right angle, toward the inside of the frame member. The application step (b) includes a step of applying an adhesive to the overhang member. The adhesion portion-forming step (c) includes a step of bonding the second surface and the overhang member.
In the aspect described above, the second surface of the substrate of the body is bonded to a surface of the overhang member facing thereto with the joint. Therefore, it is possible to absorb the influences of undulation, distortion, and stress-deformation of the solar cell panel body by thickness deformation of the joint. Furthermore, since the substrate and the frame are directly bonded to each other, the frame is prevented from widening, and an angular-U shaped member, which is necessary in a conventional solar cell panel, can be omitted. As a result, a reduction in manufacturing cost and extremely simple manufacturing are realized.

The above-mentioned method of fabricating the solar cell panel further may include (d) a step of applying a sealing agent so as to fill a recess surrounded by the end of the solar cell panel body, the adhesion portion, and the frame.
In the present invention, since the sealing portion covers the end of the solar cell panel body where the covering layer is relatively easily deteriorated, infiltration of moisture due to deterioration of the end of the solar cell panel body can be prevented.

In the above-mentioned solar cell panel, the adhesion portion may contain any of polyurethane, silicone, and a silyl group-containing polymer.
It is possible to achieve more secure joining by using a material, such as polyurethane, silicone, or a silyl group-containing polymer, in the adhesion portion.

According to the present invention, moisture is prevented from remaining between the solar cell panel body and the frame. This improves reliability of the solar cell panel. In addition, automation of the process of attaching the frame to the solar cell panel body is possible. Furthermore, the number of processes in fabricating the solar cell panel is reduced, which simplifies the fabrication and enables the solar cell panel to be fabricated at lower cost.

### Brief Description of Drawings

[FIG. 1] FIG. 1 is a partial cross-sectional view illustrating an example of the structure of a conventional solar cell panel.
[FIG. 2] FIG. 2 contains a top view and a cross-sectional view illustrating a structure of a solar cell panel according to an embodiment of the present invention.
[FIG. 3] FIG. 3 is a cross-sectional view illustrating a structure of a joint, and its vicinity, in a solar cell panel according to an embodiment of the present invention.
[FIG. 4A] FIG. 4A is a cross-sectional view illustrating an example of a method of fabricating a solar cell panel according to an embodiment of the present invention.
[FIG. 4B] FIG. 4B is a cross-sectional view illustrating an example of a method of fabricating a solar cell panel according to an embodiment of the present invention.
[FIG. 4C] FIG. 4C is a cross-sectional view illustrating an example of a method of fabricating a solar cell panel according to an embodiment of the present invention.
[FIG. 4D] FIG. 4D is a cross-sectional view illustrating an example of a method of fabricating a solar cell panel according to an embodiment of the present invention.
[FIG. 5] FIG. 5 is a cross-sectional view illustrating another structure of a joint, and its vicinity, in a solar cell panel according to an embodiment of the present invention.
[FIG. 6A] FIG. 6A is a cross-sectional view illustrating an installed state of a solar cell panel according to an embodiment of the present invention.
[FIG. 6B] FIG. 6B is a cross-sectional view illustrating an installed state of a solar cell panel according to an embodiment of the present invention.

### Explanation of Reference Signs:

- 1:: solar cell panel
- 2:: frame
- 3:: solar cell panel body
- 4:: joint
- 5:: rack
- 21:: frame member
- 22:: projection member
- 23:: overhang member
- 31:: substrate
- 32:: solar cell
- 33:: covering layer
- 34:: protection layer
- 36:: periphery
- 41:: adhesion portion
- 42:: filling portion
- 43:: sealing portion
- 44:: adhesive
- 46:: sealing agent

### Best Mode for Carrying Out the Invention

Embodiments of a solar cell panel and a method of fabricating the solar cell panel of the present invention will now be described with reference to the attached drawings.

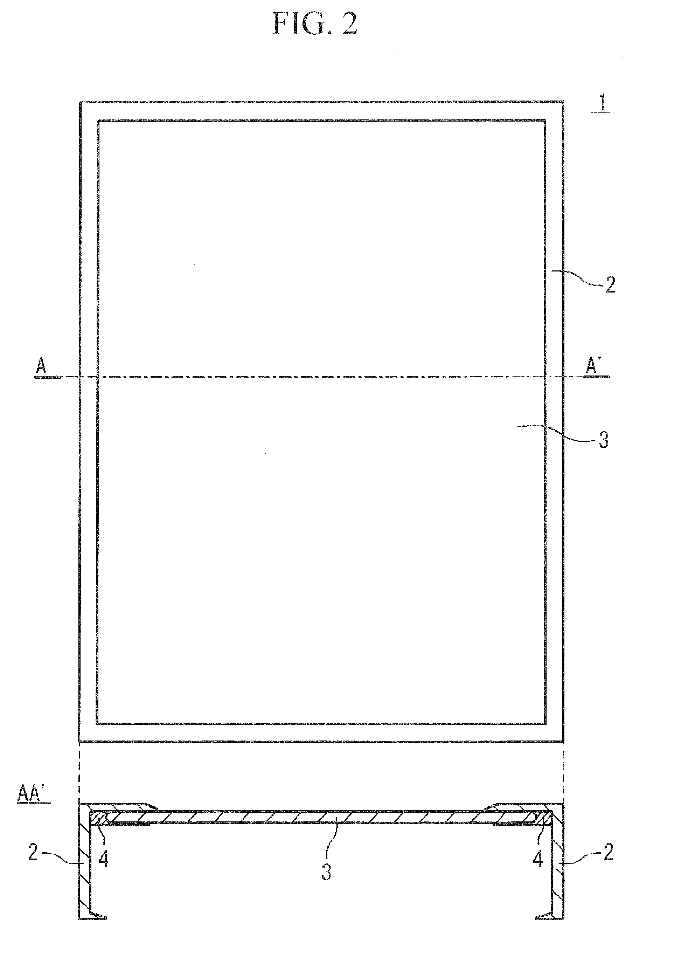

FIG. 2 contains a top view and a cross-sectional view illustrating a structure of the solar cell panel according to an embodiment of the present invention. The cross-sectional view shows the A-A' cross-section of the top view. The solar cell panel 1 includes a frame 2, a solar cell panel body 3, and a joint 4. The cross-section of the solar cell panel 1 in the direction approximately perpendicular to the A-A' cross-section is the same as that shown by the cross-sectional view of FIG. 2, except for the length of the solar cell panel body 3.

The solar cell panel body 3 includes a substrate and a plurality of solar cells mounted or formed on a first surface of the substrate. The plurality of solar cells are, for example, connected to each other in series. The solar cells are each composed of a transparent electrode layer, a photoelectric conversion layer, and a back electrode layer laminated in this order.
Examples of the solar cells include single-layer amorphous silicon thin-film solar cells; crystalline silicon solar cells such as microcrystalline silicon solar cells; silicon-germanium solar cells; and other thin-film solar cells such as multijunction (tandem) solar cells in which one to several layers of amorphous silicon solar cells and crystalline silicon solar cells or silicon-germanium solar cells are laminated. Furthermore, the solar cell panel body 3 may be one formed by bonding crystalline solar cells onto the first surface of the substrate.

The frame 2 has an approximately L-shaped cross-section and surrounds the solar cell panel body 3. The frame 2 can be formed of, for example, a metal such as aluminum. This frame 2 has the approximately L-shaped cross-section instead of the approximately angular-U shaped cross-section in the conventional technology shown in FIG. 1, and therefore does not have a portion where moisture remains, such as the angular-U-shaped portion. That is, since the periphery outside the solar cell panel body 3 does not retain any moisture, the influence of moisture on the solar cell panel body 3 is substantially reduced. This improves the weatherability and the long-term reliability of the solar cell panel 1.

The joint 4 connects the solar cell panel body 3 and the frame 2. That is, the crossbar of the "L-shape" of the approximately L-shaped cross-section of the frame 2 and a second surface, opposite to the first surface, of the substrate are connected by the joint 4. The joining is preferably accomplished with an adhesive.

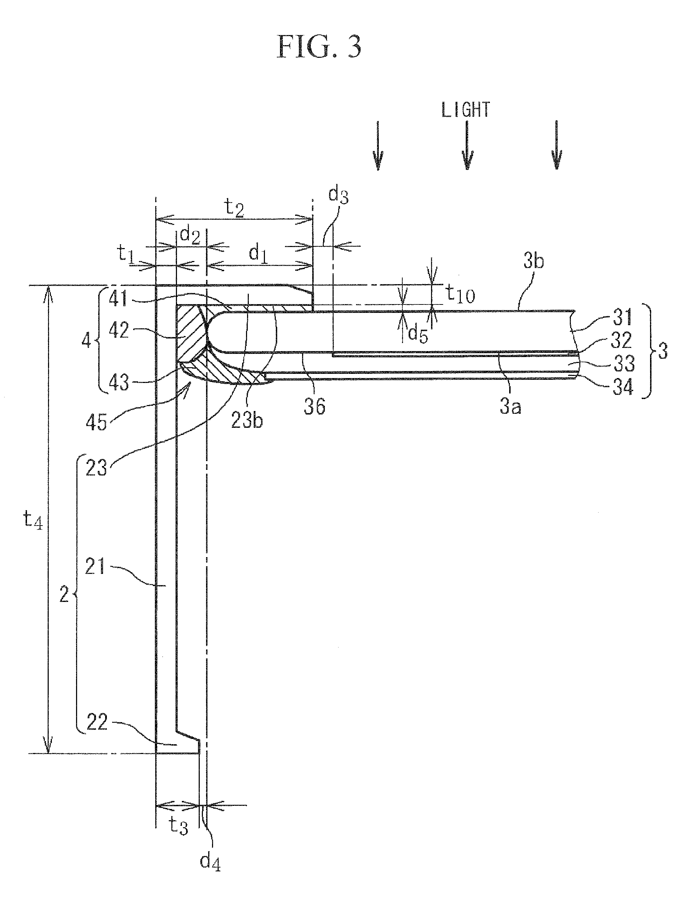

The structure of the joint 4, and its vicinity, in the solar cell panel 1 will now be described in detail. FIG. 3 is a cross-sectional view illustrating a structure of the joint, and its vicinity, in the solar cell panel according to this embodiment. That is to say, it is an enlarged view of part of the cross-sectional view of FIG. 2.

The solar cell panel body 3 includes a substrate 31, a plurality of solar cells 32, a covering layer 33, and a protection layer 34. The substrate 31 is translucent and is, for example, a glass substrate. A large substrate having a size of, for example, 1.1 m by 1.4 m by 4 mm^{t} can be used. The plurality of solar cells 32 are mounted or formed on a first surface 3a (the surface opposite to the light incident side) of the substrate 31. The details of the plurality of solar cells 32 are the same as those described in FIG. 2, but the periphery 36 of the substrate 31 is not provided with the solar cells 32. The periphery 36 is provided mainly for improving adhesion between the covering layer 33 and the substrate 31. Part of the covering layer 33 at the periphery 36 is not covered with the protection layer 34. The second surface 3b of the substrate 31 is connected to the frame 2 via the joint 4.

The covering layer 33 is provided so as to cover the substrate 31 and the plurality of solar cells 32 for protecting their surfaces without forming unnecessary space at the first surface 3a side of the substrate 31. The covering layer 33 may be a film made of a resin such as EVA (ethylenevinyl acetate). The protection layer 34 is provided so as cover the covering layer 33 disposed on the plurality of solar cells 32 at the first surface 3a side of the substrate 31 for waterproofing. The protection layer (back sheet) 34 may be a resin film containing a metal foil inside, such as PAP (PET (poly ethylene terephthalate)/Al foil/PET), for waterproofing.

The frame 2 includes a frame member 21, an overhang member 23, and a projection member 22.
The frame member 21 is the vertical bar portion of the "L-shape" of the approximately L-shaped cross-section and is provided so as to surround the outer edge of the solar cell panel body 3. The first surface 3a of the substrate 31 and the face extending in the longitudinal direction of the frame member 21 are in approximately a right angle relationship. In the case of an approximately 1 m² module that withstands 2400 Pa, which is a requirement in a mechanical load test as prescribed by an IEC standard, and that is effective for power generation, the height t4 and the thickness t1 of the frame member 21 are about 35 mm or more and 50 mm or less and about 2 mm or more and 4 mm or less, respectively, when the frame 2 is made of, for example, aluminum, in consideration of the strength when serving as a frame. The IEC standard mentioned here is IEC 61646: 1996, "Thin-film terrestrial photovoltaic (PV) modules Design qualification and type approval". This IEC standard is also a JIS standard: JIS C 8991: 2004 (IEC 61646: 1996), "Thin-film terrestrial photovoltaic (PV) modules - Requirements for design qualification and type approval".

The overhang member 23 is a portion corresponding to the crossbar portion of the "L-shape" of the approximately L-shaped cross-section and is connected to the frame member 21 at substantially a right angle so as to protrude toward the inside of the frame member 21. The overhang member 23 has a thickness t10 and protrudes by a length t2 from the frame member 21. The thickness t10 is preferably as small as possible. If the thickness is large, dirt and dust easily gather near a region where the end of the overhang member 23 and the second surface 3b of the substrate 31 meet each other. In such a case, a shadow falls on that region, which adversely affects the power generation. However, because a smaller thickness causes a decrease in the strength, a lower limit of the thickness is determined. For example, in the case of the aluminum frame 2, the thickness t10 is about 2 mm or more and 4 mm or less.

The length t2 is determined by the relationship with the solar cells 32 of the solar cell panel body 3. On this occasion, the length t2 is preferably determined such that the periphery 36, where cell films are not provided, is shielded so as not to form a shadow on an effective power-generating area contributing to power generation among the cell films of the solar cells 32, but not to expose the covering layer 33 and the protection layer 34 to light through the periphery 36.
The lower limit of the joint width d1 of the substrate 31 and the overhang member 23 is determined such that the solar cell panel body 3 is held with sufficient joining (adhesion). Furthermore, the joint width d1 is determined such that a region where a shadow of the overhang member 23 falls on the substrate 31 is narrow (the shadow of the overhang member 23 does not reach the region where the solar cells 32 are disposed) and that the joining strength is not excessively high and the stress due to the difference in thermal expansion of the substrate 31 and the overhang member 23 is small. The width d1 is, for example, about 5 mm or more and 10 mm or less in the case of the aluminum frame 2.
The lower limit of the distance d2 from the end of the frame member 21 to the end of the solar cell panel body 3 is determined such that the difference in thermal expansion of the frame 2 and the substrate 31 can be absorbed and a distance d4 described below can be secured. The upper limit of the distance d2 is determined in consideration of workability, as well as the material costs of a filling portion 42 formed from the end of the frame member 21 to the end of the solar cell panel body 3. The distance d2 is, for example, about 1 mm or more in the case of the aluminum frame 2.
The lower limit of the distance d3 between the end of the solar cells 32 and the end of the overhang member 23 is determined to form a positional relationship such that the shadow of the overhang member 23 does not fall on the solar cells 32, as far as possible, when light is incident on the substrate 31. The upper limit of the distance d3 is determined such that the region where the solar cells 32 are not disposed on the substrate 31 is as small as possible. On this occasion, the distance d3 is preferably determined such that the periphery 36, where cell films are not provided, is shielded so as not to form a shadow on an effective power-generating area contributing to power generation among the cell films of the solar cells 32, but not to expose the covering layer 33 and the protection layer 34 to light through the periphery 36.

The projection member 22 is connected to the frame member 21 at substantially a right angle so as to protrude toward the inside of the frame member 21 at the other end of the frame member 21 with respect to the connecting portion of the overhang member 23. The projection member 22 protrudes by a length t3. However, the length of the projection member 22 is shorter than that of the overhang member 23, that is, length t2 > length t3.
In the conventional technology as shown in FIG. 1, a shape-maintaining portion 102-3 corresponding to the projection member 22 functions as a strength-enhancing member for reducing widening of the frame 102. However, in this embodiment, since the solar cell panel body 3 and the frame 2 are directly bonded to each other with an adhesive, the solar cell panel body 3 itself also prevents widening of the frame 2. Accordingly, the projection member 22 is not required to have a shape that protrudes by a large amount as in the shape-maintaining portion 102-3. This can reduce the cost. However, the projection member 22 should have a certain length t3 for the stability of the frame 2. The length t3 is, for example, about 3 mm or more in the case of the aluminum frame 2.

In such a case, the distance d4 between the end of the solar cell panel body 3 and the end of the projection member 22 is, for example, about 0 mm or more, in the case of the aluminum frame 2. This distance is determined such that the solar cell panel body 3 is automatically disposed inside of the completed frame 2 with an automated alignment apparatus. That is, because a solar cell panel can be fabricated merely by putting the solar cell panel body on the completed frame 2, this process can be automated. In the conventional case, the frame is assembled on the solar cell panel body by setting each edge of the solar cell panel body 3 in the respective sides of the frame. This setting cannot be automated due to, for example, undulation or distortion of the substrate. Consequently, this process is manually conducted. In the present invention, this process can be automated, therefore improving the manufacturing efficiency and through-put and allowing a reduction in costs.

The joint 4 includes an adhesion portion 41, a filling portion 42, and a sealing portion 43.
The adhesion portion 41 bonds the second surface 3b of the substrate 31, opposite to the first surface 3a, and the surface 23b of the overhang member 23, facing the second surface 3b. The lower limit of the thickness d5 of the adhesion portion 41 is determined in consideration of the adhesion strength, and the upper limit is determined in consideration of, for example, material costs.
Furthermore, the thickness d5 is preferably larger than half of the difference between thermal elongation of the substrate 31 of the solar cell panel body 3 and that of the frame 2. In the case of a rectangular solar cell panel body 3 (module), this difference in the thermal elongation is calculated based on the long sides of the rectangle, between a temperature (example: 25°C) when assembled (adhesion) and a highest temperature (example: 85°C) when used outdoors. Such thermal elongation occurs symmetrically on both sides with respect to the midpoint of a side defined as a fixed point. Accordingly, the degree of distortion at one side is half of the total. Therefore, the thickness d5 is within the above-mentioned range, provided that the adhesive at the adhesion portion 41 bent by 45 degrees. The thickness is, for example, about 1 mm or more in the case of the aluminum frame 2. Furthermore, even if the filling portion 42 is not provided, water remaining in a recess 45 surrounded by the end of the solar cell panel body 3, the adhesion portion 41, and the frame 2 readily evaporates compared to the case of an approximately angular-U shaped cross-section, because the recess 45 is exposed to the outside air.

The filling portion 42 is provided so as to fill the recess 45 surrounded by the end of the solar cell panel body 3, the adhesion portion 41, and the frame 2. This prevents moisture from entering and remaining in the recess 45, which significantly reduces deterioration of the solar cell panel body 3 due to moisture. In addition, since the upper portion of the filling portion 42 is further exposed to the outside air, hydroscopic water (moisture) evaporates more readily even if the hydroscopic water (moisture) adheres to this portion.

The sealing portion 43 is disposed on the filling portion 42 so as to cover the end of the solar cell panel body 3.
This end is a portion of the covering layer 33 which is not covered with the protection layer 34. Since the end is not provided with the solar cells 32, light is directly incident on the covering layer 33 near the end without being absorbed in the solar cells 32. Consequently, the covering layer 33 at this portion is relatively easily deteriorated, and infiltration of hydroscopic water (moisture) from the outside easily occurs as the deterioration proceeds. The sealing portion 43 protects this portion and the vicinity thereof from the hydroscopic water (moisture). In addition, since the upper portion of the sealing portion 43 is further exposed to the outside air, hydroscopic water (moisture) evaporates more readily even if the hydroscopic water (moisture) adheres to this portion.

The adhesive of the adhesion portion 41 is an elastic adhesive having weatherability. Examples of such an adhesive include polyurethane, silicone, and silyl group-containing polymers. A specific example is "Super X" (trade name) manufactured by Cemedine Co., Ltd. The adhesive used for the adhesion portion 41 can be used as the filling portion 42 and the sealing portion 43 by applying an excess amount of the adhesive or overcoating the adhesive. In such a case, the process is simplified compared to the case where different kinds of materials are applied.

The filling portion 42 and the sealing portion 43 may be made of materials that are used in the conventional technology. Examples of the materials of the filling portion 42 and the sealing portion 43 include polyurethane, silicone, and silyl group-containing polymers.

In this embodiment, when the frame 2 and the solar cell panel body 3 are strongly joined to each other, breakage at the adhesion portion 41 may be caused by a difference in thermal expansion of the two, or both ends of the solar cell panel body 3 may be deformed as a result of being restrained by the frame 2 if the temperature of only the solar cell panel body 3 is increased. However, since the adhesion portion 41 is made of an elastic adhesive, this elastic adhesive absorbs the difference in the thermal elongation. Therefore, breakage at part of the adhesion portion 41 and the deformation of the solar cell panel body 3 are significantly reduced. As a result, stable joining can be maintained.

In some cases of frames having approximately angular-U shaped cross-sections in the conventional technology, a structure for bonding the frames to protection layers is used. In such cases, the protection layers each have a multilayer structure composed of, for example, PET/Al/PET. Therefore, the internal adhesion is low, which may decrease the adhesion between the solar cell panel body and the frame, as a result. In this embodiment, the frame 2 is bonded to the substrate 31 of the solar cell panel body 3 with an adhesive. That is, the frame 2 is bonded to the second surface 3b of the substrate 31 of the solar cell panel body 3, which enhances adhesion reliability compared to that in the conventional cases.

In this embodiment, since the solar cell panel body 3 is bonded to the frame 2, a gasket between the substrate and the frame that is used in the conventional frame having an approximately angular-U shaped frame can be omitted. This allows a reduction in cost.

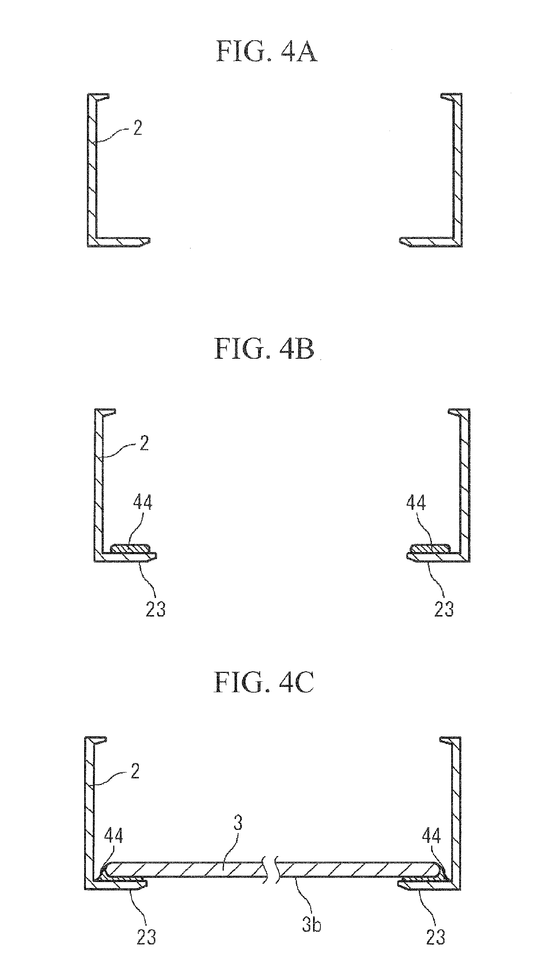

A method of fabricating the solar cell panel according to this embodiment will now be described. FIGS. 4A to 4D are cross-sectional views illustrating an example of the method of fabricating the solar cell panel according to this embodiment. FIGS. 4A to 4D show the A-A' cross-section of FIG. 2.
As shown in FIG. 4A, a frame 2, which is described in FIGS. 2 and 3, is formed (prepared) by assembling it. That is, the frame 2 is not assembled by attaching each member of the frame 2 to the solar cell panel body 3, but is assembled in advance. Accordingly, this process including the assembling of the frame 2 can be easily conducted automatically with a prescribed manufacturing apparatus.

Subsequently, as shown in FIG. 4B, the above-mentioned polyurethane serving as the adhesive 44 is applied to the overhang member 23. The overhang member 23 has a flat application face, and the frame member 21 and the projection member 22 have such shapes as not to impede the application (for example, they do not have shapes covering or surrounding the application face). That is, since the frame does not have a shape that impedes the application, such as an approximately angular-U shaped cross-section, this application process of the adhesive 44 can be easily conducted automatically with a prescribed manufacturing apparatus. In addition, the adhesive 44 is automatically and sequentially applied and is hence uniformly applied without unevenness.

Then, as shown in FIG. 4C, a separately produced solar cell panel body 3 is pressed against the frame 2 with the second surface 3b of the substrate 31 positioned downward. As described above, since the projection member 22 of the frame 2 does not protrude by a large amount toward the inside of the frame 2, the solar cell panel body 3 can be easily inserted into the inside of the assembled frame 2 automatically with a prescribed manufacturing apparatus. Then, as required, drying treatment and heating treatment are conducted. As a result, the adhesion portion 41 is formed, and the solar cell panel body 3 is bonded to the frame 2. The bonding is conducted by simply pressing the solar cell panel body 3 into the adhesive 44 continuously and uniformly applied to the flat overhang member 23, and, thereby, the bonding can be easily conducted for the entire interface between the substrate 31 of the solar cell panel body 3 and the overhang member 23 of the frame 2. Therefore, the reliability of the adhesion is significantly increased.

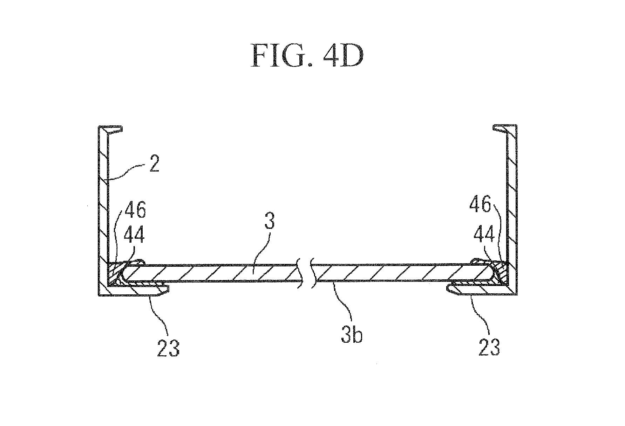

Subsequently, as shown in FIG. 4D, a sealing agent 46 is applied to fill the gap between the end of the solar cell panel body 3 and the frame 2. On this occasion, the sealing agent 46 is applied so as to also cover the covering layer 33 exposed at the periphery 36 of the solar cell panel body 3. Also in this step, since the frame member 21 and the projection member 22 do not have shapes that impede the application, this application process of the sealing agent 46 can be easily conducted automatically with a prescribed manufacturing apparatus. Then, as required, drying treatment and heating treatment are conducted. As a result, the filling portion 42 and the sealing portion 43 are formed, and the gap near the end of the solar cell panel body 3 is filled to protect the covering layer 33. The sealing agent for the sealing portion 43 may be different from that of the filling portion 42.
According to the above, the solar cell panel is produced.

In the conventional technology, each member of the respective sides of the frame having an approximately angular-U shaped cross-section is manually attached to the solar cell panel body 3. This is because it is very difficult to automatically fit the solar cell panel body into the "angular-U" portion of the approximately angular-U shaped cross-section, due to the influence of, for example, undulation of the substrate of the solar cell panel body and unevenness in the thickness of the covering layer 33. In addition, in the case where a sealing agent or an adhesive is applied to the "angular-U" portion and the solar cell panel body is fitted thereinto, a high-skill technique is required to uniformly apply the sealing agent or the adhesive between the "angular-U" portion and the solar cell panel body. Therefore, in the frame of the conventional technology that has an approximately angular-U shaped cross-section, the process of bonding the frame and the solar cell panel body has not been automated.

However, in this embodiment, since the frame 2 has an approximately L-shaped cross-section instead of the approximately angular-U shaped cross-section, the frame 2 and the solar cell panel body 3 are bonded and connected to each other by simply pressing the solar cell panel body 3 onto the frame 2 to which the adhesive 44 is applied. That is, the solar cell panel body 3 is not required to be fitted into a member having an approximately angular-U shaped cross-section, and can be bonded to the frame 2 by a simple process of putting the solar cell panel body 3 on the frame 2 having the approximately L-shaped cross-section and pressing it thereto. This allows the process shown in FIGS. 4A to 4D to be automated, which improves productivity. On this occasion, since the solar cell panel body 3 is fixed only at the face provided with the adhesive 44, the influence of, for example, undulation of the substrate of the solar cell panel body and unevenness in the thickness of the covering layer 33 can be absorbed by the thickness of the adhesive 44.

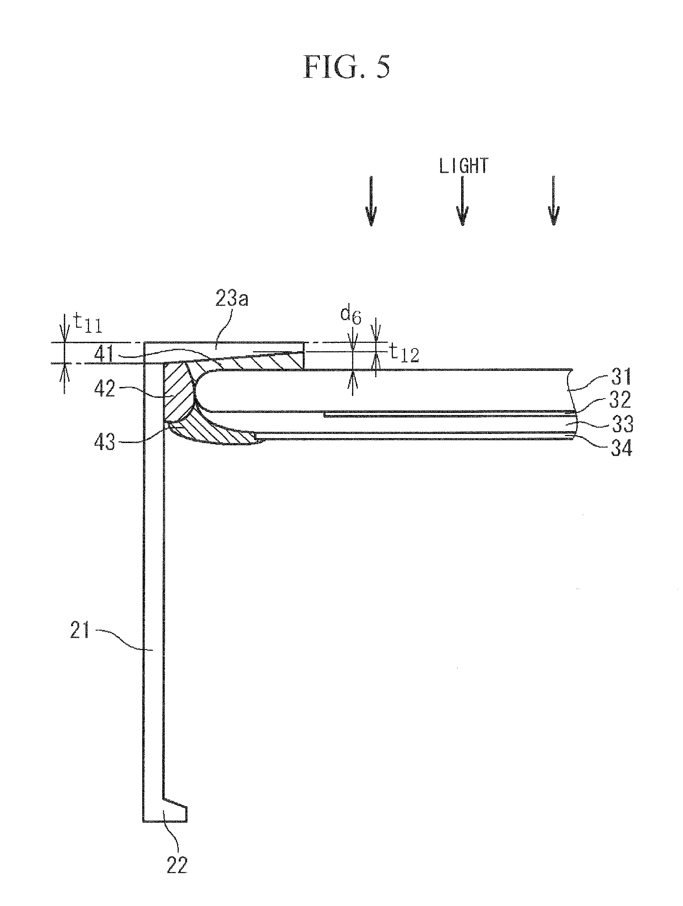

FIG. 5 is a cross-sectional view illustrating another structure of a joint, and its vicinity, in the solar cell panel according to this embodiment. That is, FIG. 5 is an enlarged view of part of the cross-sectional view in FIG. 2. Basically, FIG. 5 is the same as FIG. 3 except that the overhang member 23a becomes thinner with the distance from the connecting portion with the frame member 21. That is, the thickness t11 of the overhang member 23a at the connecting portion with the frame member 21 is larger than the thickness t12 of the overhang member 23a at the end. In this case, the distance d6 corresponding to the thickness of the adhesion portion 41 can be enlarged compared to the distance d5 in the case shown in FIG. 3. However, it is preferable that the sum of the thickness t12 and the distance d6 be approximately the same as that of the thickness t10 and the distance d5. If this portion is thicker, dirt and dust easily gather on the substrate 31 at the end of the overhang member 23a, forming a shadow, which adversely affects the power generation.

With this, the adhesion portion 41 has a relatively large thickness (corresponding to the distance d6), which enhances the elasticity effect of the elastic adhesive used as the adhesion portion 41. That is, it is possible to significantly reduce breakages at the adhesion portion 41 caused by stress due to, for example, a difference in thermal expansion, as well as deformation caused by the stress generated by restraint of both ends of the solar cell panel body 3 by the frame 2, which occur when the frame 2 and the solar cell panel body 3 are strongly joined to each other.

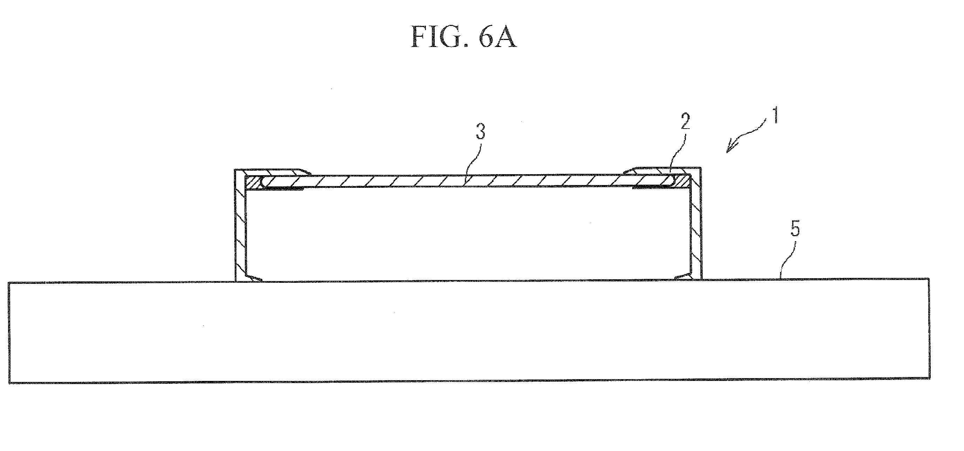

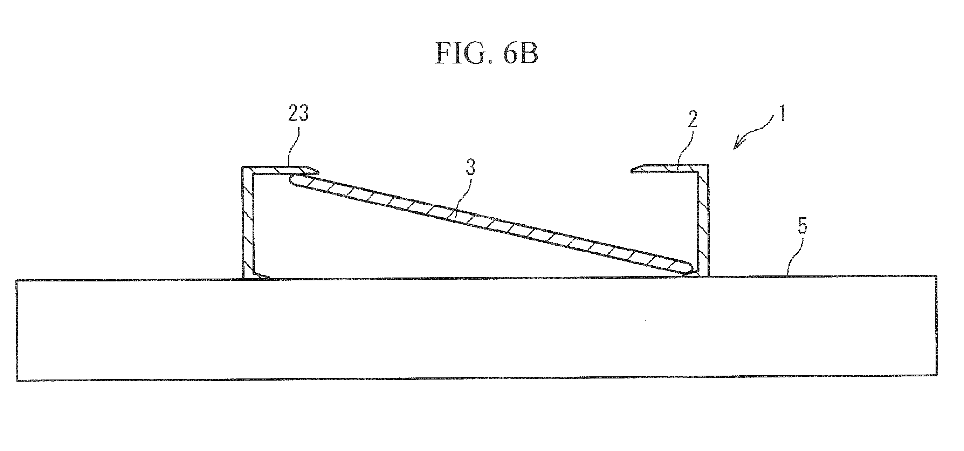

In this embodiment, the solar cell panel body 3 is strongly bonded to the frame 2 with an adhesive at the joint 4. Furthermore, in the event of peeling off of the adhesive, the solar cell panel body 3 will not fall from the frame 2. This is shown in FIGS. 6A and 6B. FIGS. 6A and 6B are cross-sectional views illustrating an installed state of a solar cell panel according to this embodiment. As shown in FIG. 6A, the solar cell panel 1 is installed on a rack 5. In such a case, if the adhesive at the joint 4 is peeled off, as shown in FIG. 6B, one end of the solar cell panel body 3 is caught on the overhang member 23 of the frame 2, and the other end is prohibited from moving by the rack 5. Consequently, the solar cell panel body 3 does not fall out.

In the embodiment described above, an insulating sheet such as a PAP sheet is used as an example of the protection layer 34, but the protection layer 34 may be a glass plate.
In such a case, the protection layer 34 and the frame 2 may be bonded to each other by placing the solar cell panel body 3 in the opposite orientation.

In the present invention, a solar cell panel that hardly retains any moisture between the solar cell panel body and the frame is obtained by employing the new frame structure and
adhesion structure. This allows an improvement in reliability of the solar cell panel. In addition, a method of fabricating the solar cell panel that enables automation of the process of attaching the frame to the solar cell panel body is obtained
by employing the new frame structure and adhesion structure.
Furthermore, the method of fabricating the solar cell panel reduces the number of manufacturing processes and enables easy fabrication of the solar cell panel at lower cost.

The present invention is not limited to the above-described embodiments. Naturally, each embodiment can be optionally modified or varied within the scope of the technical concept of the present invention.

## Claims

1. A solar cell panel comprising:
a solar cell panel body including a substrate having photoelectric conversion elements mounted on a first surface;
a frame having an approximately L-shaped cross-section;
and
a joint for bonding the frame and a second surface, opposite to the first surface, of the substrate.

2. The solar cell panel according to Claim 1, wherein
the frame includes
a frame member surrounding the outer edge of the solar cell panel body in a frame shape; and
an overhang member being connected to the frame member at substantially a right angle, toward the inside of the frame member, and
the joint bonds the second surface and the overhang member.

3. The solar cell panel according to Claim 2, wherein
a shadow of an adhesion region of the overhang member and the solar cell panel body, which falls on the first surface, is outside of a region having the photoelectric conversion elements.

4. The solar cell panel according to Claim 2 or 3, wherein
the overhang member becomes thinner with the distance from the connecting portion of the frame member.

5. The solar cell panel according to any one of Claims 2 to 4, wherein
the frame member includes a projection member that is connected to the frame member at substantially a right angle, toward the inside of the frame member at the other end of the frame member with respect to the connecting portion of the overhang member and is shorter than the overhang member.

6. The solar cell panel according to any one of Claims 1 to 5, wherein
the joint includes
an adhesion portion in which the second surface and the frame are bonded, and
a filling portion provided so as to fill a recess surrounded by the end of the solar cell panel body, the adhesion portion, and the frame.

7. The solar cell panel according to Claim 6, wherein
the joint further includes
a sealing portion disposed on the filling portion so as to cover the end of the solar cell panel body.

8. The solar cell panel according to Claim 6 or 7, wherein
the adhesion portion contains any of polyurethane, silicone, and a silyl group-containing polymer.

9. A method of fabricating a solar cell panel comprising:
(a) a step of producing a solar cell panel body including a substrate having photoelectric conversion elements mounted on a first surface;
(b) a step of applying an adhesive to a frame having an approximately L-shaped cross-section; and
(c) a step of forming an adhesion portion bonding the frame and a second surface, opposite to the first surface, of the substrate.

10. The method of fabricating a solar cell panel according to Claim 9, wherein
the frame includes
a frame member surrounding an outer edge of the solar cell panel body in a frame shape; and
an overhang member being connected to the frame member at substantially a right angle, toward the inside of the frame member,
the step (b) includes
(b1) a step of applying the adhesive to the overhang member, and
the step (c) includes
(c1) a step of bonding the second surface and the overhang member.

11. The method of fabricating a solar cell panel according to Claim 9 or 10 further comprising:
(d) a step of applying a sealing agent so as to fill a recess surrounded by the end of the solar cell panel body, the adhesion portion, and the frame.

12. The method of fabricating a solar cell panel according to any one of Claims 9 to 11, wherein
the adhesion portion contains any of polyurethane, silicone, and a silyl group-containing polymer.
